# EUROPEAN PATENT APPLICATION

(11) **EP 1 536 484 A1**
(43) Date of publication of application: **01.06.2005**
(21) Application number: 03741311.9
(22) Date of filing: 10.07.2003
(51) Int. Cl.: H01L 29/80, H01L 21/334, H01L 51/00

(54) **ORGANIC SEMICONDUCTOR DEVICE AND METHOD FOR MANUFACTURING SAME**

(30) Priority: 15.07.2002 JP 2002205634; 15.07.2002 JP 2002205635
(71) Applicant: Pioneer Corporation, Tokyo 153-8654 (JP)
(72) Inventor: YOSHIZAWA, Atsushi, c/o Pioneer Corporation, Tsurugashima-shi, Saitama 350-228 (JP)
(74) Representative: Klingseisen, Franz, Dipl.-Ing.
(86) International application number: PCT/JP2003/008761
(87) International publication number: WO 2004/008545

(57) **Abstract**

The invention provides an organic semiconductor device with a p-type organic semiconductor layer sandwiched between a source electrode and a drain electrode including an n-type organic semiconductor layer formed in an intermediate portion of the p-type organic semiconductor layer and a gate electrode embedded in the n-type organic semiconductor layer, and an organic semiconductor device with an n-type organic semiconductor layer sandwiched between a source electrode and a drain electrode includes a p-type organic semiconductor layer formed in an intermediate portion of the n-type organic semiconductor layer and a gate electrode embedded in the p-type organic semiconductor layer, thereby suppressing a leak current generated between the electrodes. The invention also provides an organic semiconductor device including an organic semiconductor layer sandwiched between a source electrode and a drain electrode and having a carrier transporting property, and a gate electrode constituted of at least two intermediate electrode pieces which are embedded in the organic semiconductor layer, are respectively provided in at least two planes separated from and parallel to the source electrode and the drain electrode, and are positioned in a direction across the layer thickness. The gate electrode is embedded by fusing the organic semiconductor layer.

## Description

### TECHNICAL FIELD

The present invention relates to an organic semiconductor device provided with an organic semiconductor layer constituted of an organic compound having a carrier transporting property, and a producing method therefor.

### BACKGROUND ART

As a voltage application to an organic semiconductor layer causes a charge density increase therein, a current can be induced between a pair of electrodes provided on such organic semiconductor layer. For example, in an organic semiconductor device such as an organic transistor of a vertical SIT (static induction transistor) structure, a gate electrode, positioned between a source electrode and a drain electrode sandwiching an organic semiconductor layer, applies a voltage across the thickness of such organic semiconductor layer to switch a current in a direction of thickness of the organic semiconductor layer.

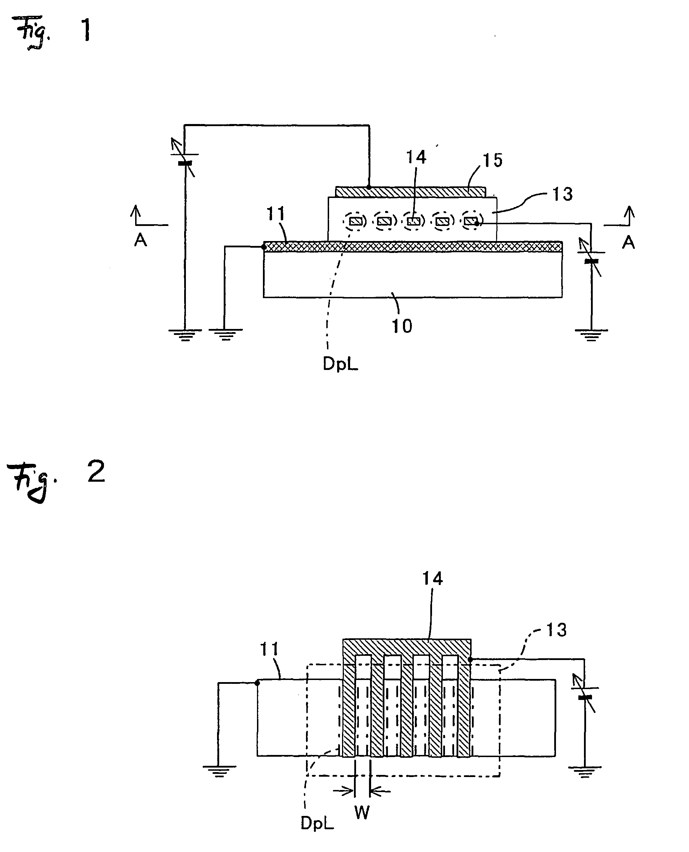

An SIT, as shown in Fig. 1, has a three-terminal structure in which an organic semiconductor layer 13 is sandwiched between a pair of a source electrode 11 and a drain electrode 15 and a gate electrode 14 is formed within the thickness of the organic semiconductor layer. A voltage is applied to the gate electrode, and a current between the source electrode and the drain electrode can be controlled by a depletion layer DpL generated in the organic semiconductor layer.

In the organic transistor of SIT structure, a carrier displacement across the film thickness between the source electrode and the drain electrode is prevented by plural depletion layers DpL formed in the organic semiconductor layer around plural slat-shaped branches of the gate electrode 14 receiving for example a positive charge.

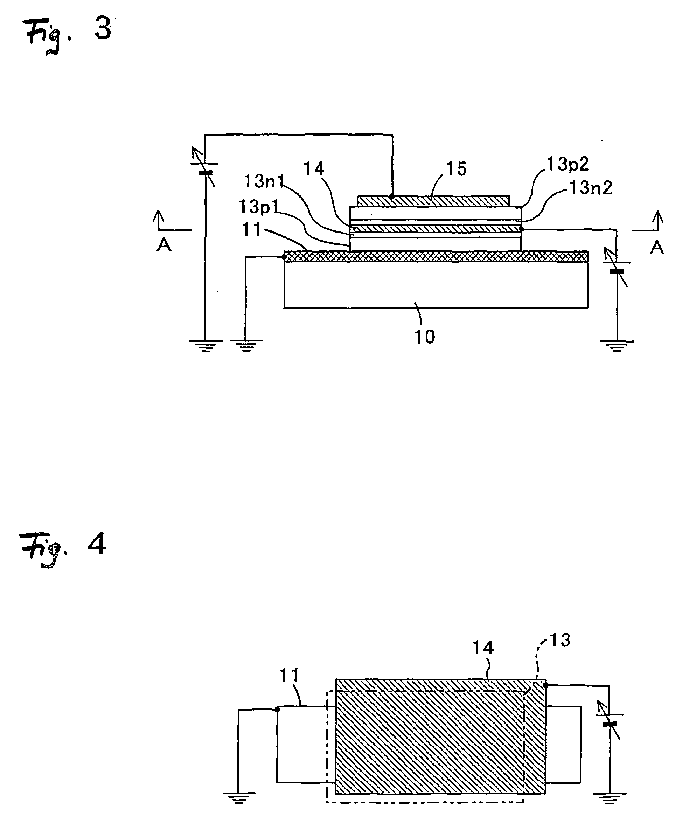

However, in case each depletion layer DpL has an insufficient spreading, a gap W between the slat-shaped branches of the gate electrode 14 as shown in Fig. 2 cannot be filled with the depletion layer DpL, thereby resulting in an increase in a leak current. Thus, the gate electrode has to be formed with a fine-structured mask in order to reduce the gap between the slat-shaped branches of the gate electrode, thereby preventing the carrier displacement and decreasing the leak current.

In general, in an organic transistor of an SIT structure, the organic semiconductor layer has a thickness in the order of several hundred nanometers and the gate electrode formed between the source electrode and the drain electrode has a thickness of 50 to 100 nm. Thus, in case of forming the organic semiconductor layer, the gate electrode and the organic semiconductor layer by successive film formations in the organic transistor, the shape of the plural slat-shaped branches of the gate electrode is transferred onto the organic semiconductor layer and the drain electrode to be deposited in ensuing steps, thereby forming irregularities on the surface and inducing an increase in the leak current.

A problem to be solved by the present invention is to provide an organic semiconductor device capable suppressing generation of a leak current between the electrodes.

### DISCLOSURE OF THE INVENTION

The present invention provides an organic semiconductor device comprising: a source electrode; a drain electrode; and a p-type organic semiconductor layer sandwiched between the source electrode and the drain electrode, characterized by further comprising an n-type organic semiconductor layer formed in an intermediate portion of the p-type organic semiconductor layer; and a gate electrode embedded in the n-type organic semiconductor layer.

The present invention also provides an organic semiconductor device comprising: a source electrode; a drain electrode; and a n-type organic semiconductor layer sandwiched between the source electrode and the drain electrode, characterized by further comprising a p-type organic semiconductor layer formed in an intermediate portion of said n-type organic semiconductor layer and a gate electrode embedded in said p-type organic semiconductor layer.

The present invention also provides an organic semiconductor device comprising: a source electrode; a drain electrode; and an organic semiconductor layer sandwiched between the source electrode and the drain electrode and having a carrier transporting property, characterized by further comprising a gate electrode constituted of at least two intermediate electrode pieces which are embedded in the organic semiconductor layer, wherein the intermediate electrode pieces are respectively provided in at least two planes separated from and parallel to the source electrode and the drain electrode, and are positioned in a direction across the layer thickness.

The present invention also provides a method for producing an organic semiconductor device provided with an organic semiconductor layer formed between a source electrode and a drain electrode and embedding a gate electrode therein, the method characterized by comprising:
a first organic semiconductor layer laminating step of forming a first organic semiconductor layer on either of a source electrode and a drain electrode;
a first intermediate electrode piece laminating step of forming a first intermediate electrode piece on a part of the first organic semiconductor layer;
a second organic semiconductor layer laminating step of forming a second organic semiconductor layer on the first organic semiconductor layer and the first intermediate electrode piece;
a second intermediate electrode piece laminating step of forming a second intermediate electrode piece on a part of the second organic semiconductor layer so as to cover the source electrode and the drain electrode in a complementary manner with the first intermediate electrode piece; and
a third organic semiconductor layer laminating step of forming a third organic semiconductor layer on the second organic semiconductor layer and the second intermediate electrode piece;
wherein each of the second and third organic semiconductor layer laminating step includes an embedding step of softening the formed organic semiconductor and embedding the intermediate electrode piece.

### BRIEF DESCRIPTION OF THE DRAWINGS

Fig. 1 is a cross-sectional view showing an organic transistor.
Fig. 2 is a cross-sectional view along a line A-A in Fig. 1.
Fig. 3 is a cross-sectional view of an organic transistor embodying the present invention.
Fig. 4 is a cross-sectional view along a line A-A in Fig. 3.
Figs. 5 to 11 are cross-sectional views showing a part of manufacturing steps for an organic transistor embodying the present invention.
Figs. 12 and 13 are views showing operations of an organic transistor embodying the present invention.
Figs. 14 and 15 are cross-sectional views showing an organic transistor in another embodiment of the present invention.
Fig. 16 is a cross-sectional view showing an organic transistor-integrated organic electroluminescence device in another embodiment of the present invention.
Fig. 17 is a cross-sectional view of an organic transistor in an embodiment of the present invention.
Fig. 18 is a cross-sectional view along a line A-A in Fig. 17.
Figs. 19 to 25 are cross-sectional views showing a part of manufacturing steps for an organic transistor embodying the present invention.
Fig. 26 is a cross-sectional view of an organic transistor in another embodiment of the present invention.
Fig. 27 is a cross-sectional view along a line A-A in Fig. 26.
Fig. 28 is a cross-sectional view showing an organic transistor-integrated organic electroluminescence device in another embodiment of the present invention.
Figs. 29 to 31 are cross-sectional views showing organic transistors in other embodiments of the present invention.

### DETAILED DESCRIPTION OF THE INVENTION

As an embodiment of the organic semiconductor device of the present invention, an organic transistor will be explained with reference to the accompanying drawings.

Fig. 3 illustrates a cross section of an organic transistor of an SIT structure in an embodiment. In the organic transistor, on a source electrode formed on a substrate 10, there are laminated in succession a first p-type organic semiconductor layer 13p1, a first n-type organic semiconductor layer 13n1, a gate electrode 14, a second n-type organic semiconductor layer 13n2, a second p-type organic semiconductor layer 13p2, and a drain electrode 15. These organic semiconductor layers have a carrier transporting property, and the first p-type organic semiconductor layer 13p1 and the second p-type organic semiconductor layer 13p2 are formed by a p-type organic semiconductor material (positive hole transporting), while the first n-type organic semiconductor layer 13n1 and the second n-type organic semiconductor layer 13n2 are formed by an n-type organic semiconductor material (electron transporting). Such device includes a pnp junction, of which areas are respectively connected to a source electrode 11, a gate electrode 14 and a drain electrode 15. Therefore, the organic transistor of the present embodiment in its entire configuration constitutes an organic semiconductor device having a p-type organic semiconductor layer sandwiched between the source electrode 11 and the drain electrode 15, and a carrier displacement is controlled by the n-type organic semiconductor layer (first n-type organic semiconductor layer 13n1 and second n-type organic semiconductor layer 13n2) positioned between the p-type organic semiconductor layers (first p-type organic semiconductor layer 13p1 and second p-type organic semiconductor layer 13p2). In order to apply a control voltage uniformly to such n-type organic semiconductor layer, the gate electrode 14 is embedded in the n-type organic semiconductor layer.

As shown in Fig. 4, the gate electrode 14 is so formed, when observed from the side of the source electrode 11 or the drain electrode 15, as to cover these electrodes.

The organic transistor of the present embodiment is produced for example by a following process.

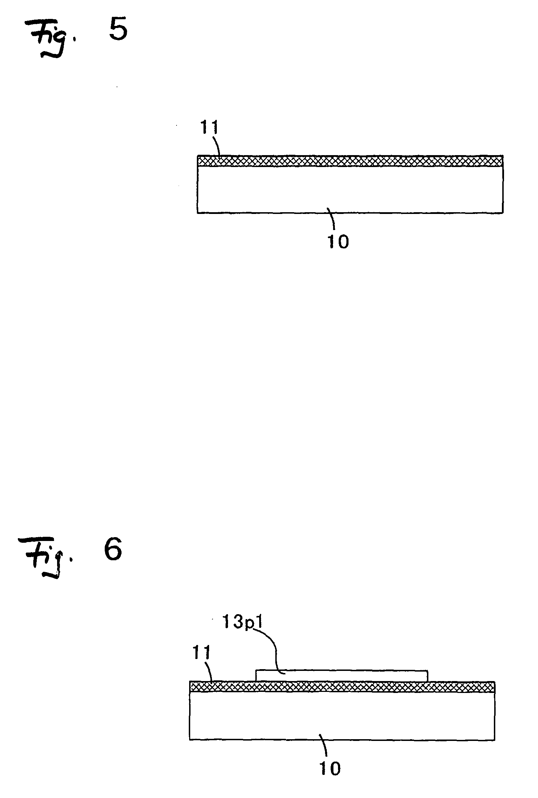

At first, a source electrode 11 is formed on a substrate 10 as shown in Fig. 5. For example a source electrode 11 of indium tin oxide (ITO) or chromium (Cr) is formed with a thickness of 50 nm by a sputtering method. Various methods such as evaporation, sputtering or CVD can be utilized for forming not only the source electrodes but also various electrodes.

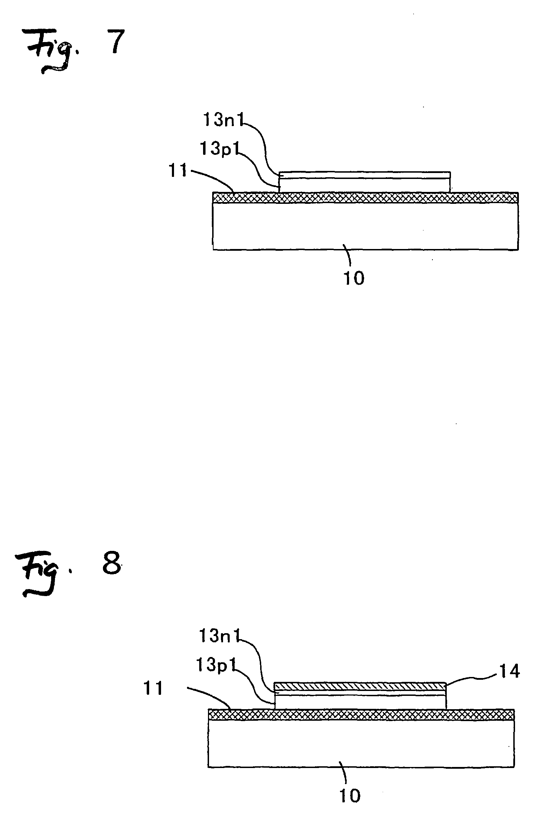

Then, as shown in Fig. 6, on the source electrode 11, a film of 4,4'-bis[N-(1-naphthyl)-N-phenylamino]-biphenyl (so-called a-NPD) is formed with a thickness of 25 nm by a resistance-heated evaporation as the first p-type organic semiconductor layer 13p1.

Then, as shown in Fig. 7, on the first p-type organic semiconductor film 13p1, a film of a porphyrin compound such as copper phthalocyanine (so-called CuPc) or a quinoline derivative such as tris(8-hydroxyquinoline) aluminum complex (so-called Alq3) is formed with a thickness of 25 nm by a resistance-heated evaporation as the first n-type organic semiconductor layer 13n1.

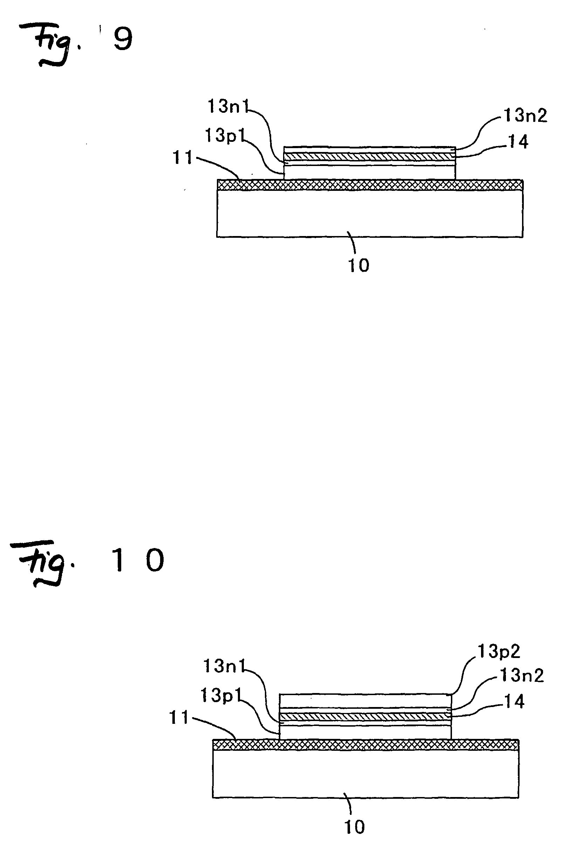

Then, as shown in Fig. 8, aluminum is formed in a flat plate shape with a thickness of 50 nm as the gate electrode 14 by a resistance-heated evaporation. Also the entire gate electrode 14 may be covered for example with an electron injection layer of a thickness of several nanometers such as of LiO₂.

Then, as shown in Fig. 9, on the gate electrode 14, a film of CuPc or Alq3 same as in the first n-type organic semiconductor layer is formed with a thickness of 25 nm as the second n-type organic semiconductor layer 13n2 by a resistance-heated evaporation.

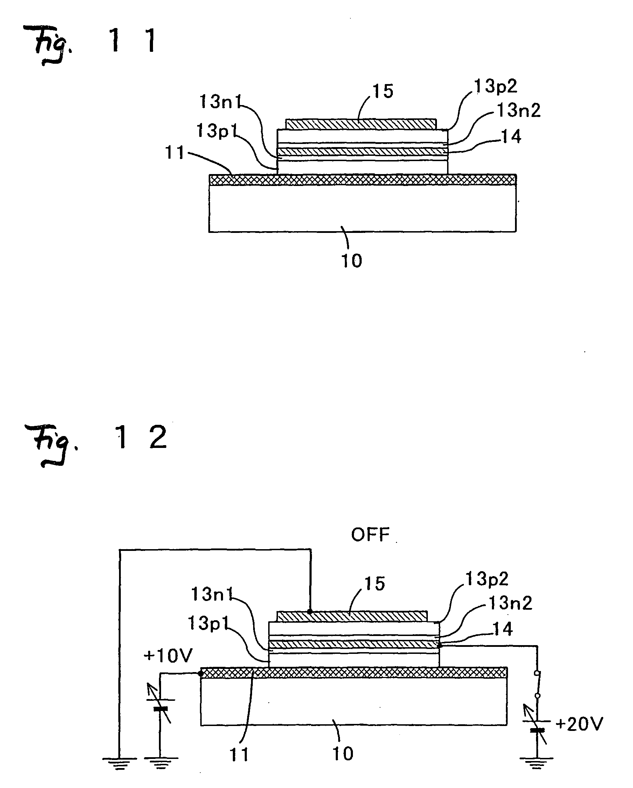

Then, as shown in Fig. 10, on the second n-type organic semiconductor layer 13n2, a film of a-NPD same as in the first p-type organic semiconductor layer is formed with a thickness of 25 nm as the second p-type organic semiconductor layer 13p2.

Finally, as shown in Fig. 11, on the second p-type organic semiconductor layer 13p2, a film of Al is formed with a thickness of 200 nm as the drain electrode 15 by a resistance-heated evaporation, thereby completing an organic transistor.

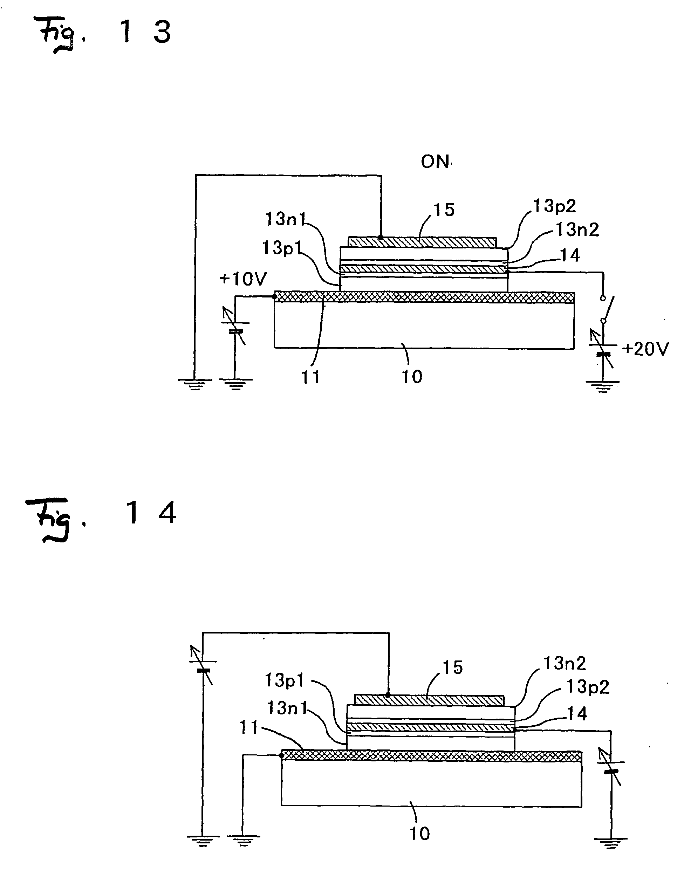

In the obtained organic transistor, for example in a state where the drain electrode 15 is grounded and the source electrode 11 is maintained at a potential of +10 V as shown in Fig. 12, a potential of +20 V applied to the gate electrode 14 elevates the barrier thereby turning off the transistor. On the other hand, in a same state where the drain electrode 15 is grounded and the source electrode 11 is maintained at a potential of +10 V, an open state of the gate electrode 14 as shown in Fig. 13 merely leaves junctions of the organic semiconductor layers whereby the transistor is turned on to permit a current therethrough.

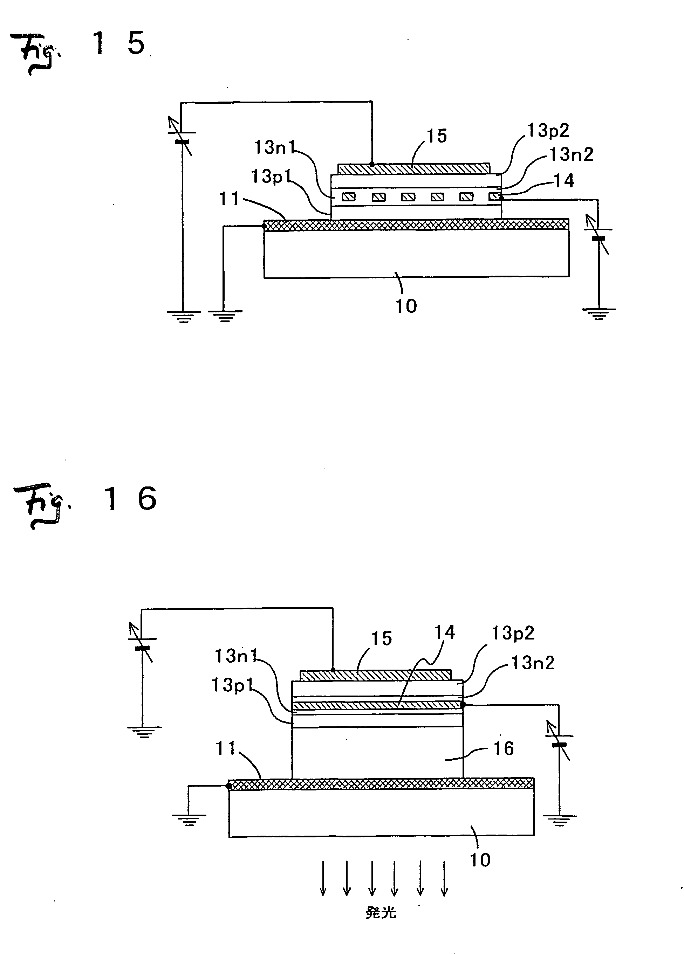

The foregoing embodiment has shown an example of a pnp junction, but an npn junction may also be adopted. In such case, the device is constituted, on a source electrode on a substrate 10 as shown in Fig. 14, of a first n-type organic semiconductor layer 13n1, a first p-type organic semiconductor layer 13p1, a gate electrode 14, a second p-type organic semiconductor layer 13p2, a second n-type organic semiconductor layer 13n2 and a drain electrode 15 laminated in succession. Therefore, the organic transistor can also be so constructed as to include a p-type organic semiconductor layer, constituted of the first p-type organic semiconductor layer 13p1 and the second p-type organic semiconductor layer 13p2, and sandwiched in the n-type organic semiconductor layer constituted of the first and second n-type organic semiconductor layers 13n1, 13n2 which are positioned between the source electrode 11 and the drain electrode 15, and also the gate electrode 14 embedded in the first p-type organic semiconductor layer 13p1 and the second p-type organic semiconductor layer 13p2.

Also in the foregoing embodiment, the gate electrode 14 is formed as flat plate shape, but the gate electrode 14 may also be formed, as shown in Fig. 15, as plural slat-shaped branches in a comb-like or screen-like pattern. In such case, the gate electrode may be formed in any shape that can apply a voltage substantially uniformly to the contacting organic semiconductor layer.

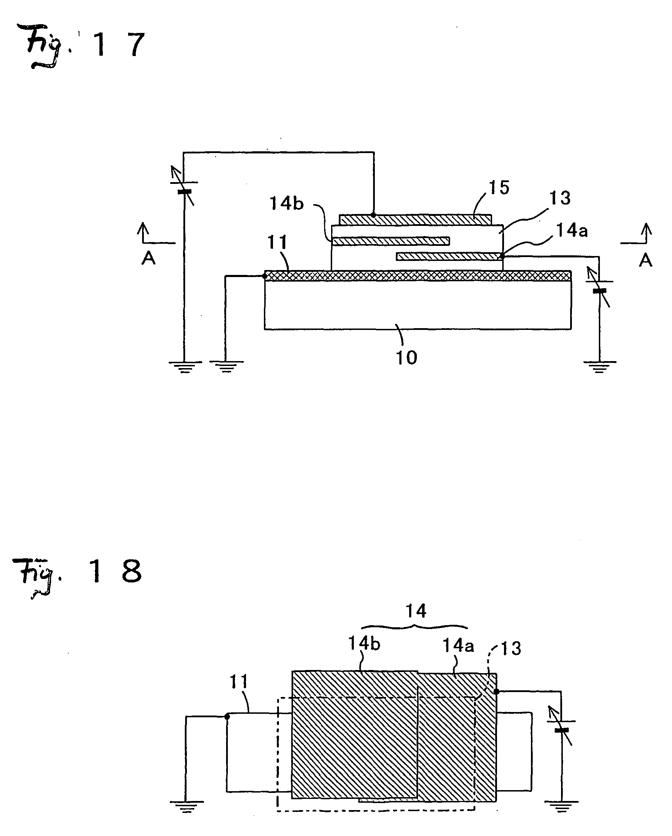

Furthermore, in the organic transistor of the aforementioned SIT structure, an electroluminescence device integral with an organic transistor can be constructed, as shown in Fig. 16, by forming the first p-type organic semiconductor layer 13p1 and the second p-type organic semiconductor layer 13p2 as positive hole transport layers and providing an organic light-emitting layer 16 of an electron transporting property between the source electrode 11 and the first p-type organic semiconductor layer 13p1. It is thus rendered possible to form plural organic EL devices, each provided with an active device formed by organic material layers including an organic light-emitting layer constituted of at least a film of an organic compound showing an electroluminescence (EL) or a light emission by a current injection, in a predetermined pattern such as a matrix on a display panel substrate.

An organic EL device is formed by laminating organic material layers in succession between a pair of electrode layers which are provided on a substrate and one of which at a light emitting side is constituted of a transparent material. For example in a top-emission configuration, the organic light emission layer 16 may be provided between the drain electrode 15 and the second p-type organic semiconductor layer 13p2 in a configuration opposite to that shown in Fig. 16.

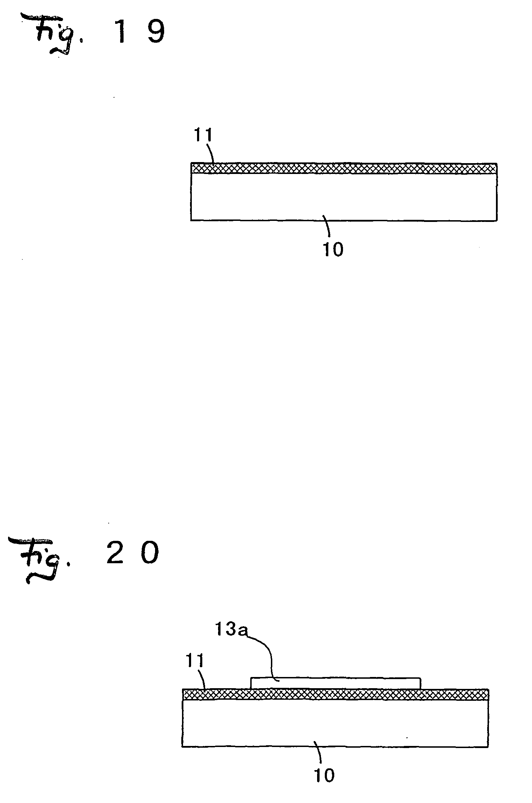

Fig. 17 shows a cross section of an organic transistor of SIT structure of another embodiment. On a substrate 10, an organic semiconductor layer 13 for example of p-type, having a carrier transporting property, is so provided as to be sandwiched between a source electrode 11 and a drain electrode 15. The organic semiconductor layer 13 may be p-type (positive hole transporting) or n-type (electron transporting) and can be constituted of a material having at least either of the positive hole transporting property and the electron transporting property. In the organic semiconductor layer 13, there is embedded a gate electrode constituted of two intermediate electrode pieces 14a, 14b each having a flat plate shape. The intermediate electrode pieces 14a, 14b are separated in mutually parallel manner between the source electrode 11 and the drain electrode 15. As shown in Fig. 18, the intermediate electrode pieces 14a, 14b are mutually connected electrically as a gate electrode 14 and are so formed, when observed from the side of the source electrode 11 or the drain electrode 15, as to cover these electrodes in a mutually complementary manner. The intermediate electrode pieces 14a, 14b are provided in a mutually separate manner respectively in two planes between the source electrode 11 and the drain electrode 15, but intermediate electrode pieces may also be provided in three or more planes as long as they are between the source electrode 11 and the drain electrode 15.

The organic transistor of the present embodiment is produced for example by a following process.

At first, a source electrode 11 is formed on a substrate 10 as shown in Fig. 19. For example a source electrode 11 of indium tin oxide (ITO) or chromium (Cr) is formed with a thickness of 50 nm by a sputtering method. Various methods such as evaporation, sputtering or CVD can be utilized for forming not only the source electrodes but also various electrodes.

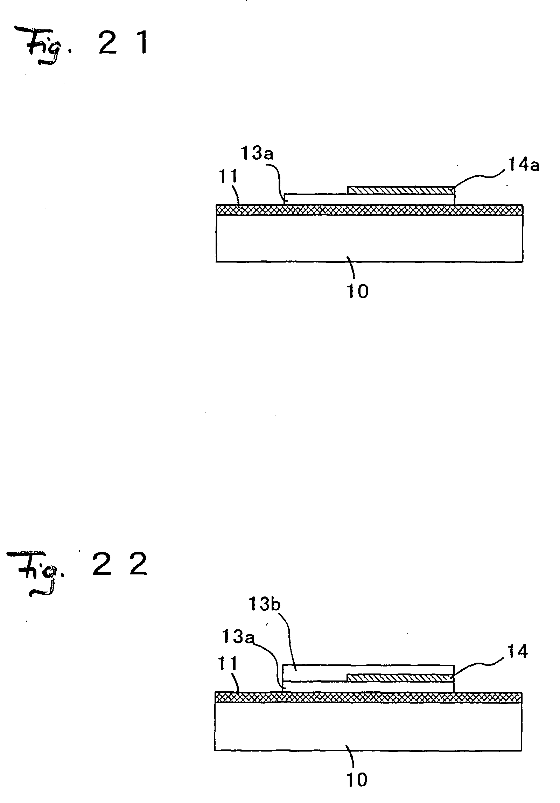

Then, as shown in Fig. 20, on the source electrode 11, a film of 4,4'-bis[N-(1-naphthyl)-N-phenylamino]-biphenyl (so-called a-NPD) is formed with a thickness of 50 nm by a resistance-heated evaporation as the first organic semiconductor layer 13a.

Then, as shown in Fig. 21, on a part of an upper surface of the first organic semiconductor layer 13a, Al is formed in a flat plate shape with a thickness of 50 nm by a resistance-heated evaporation as the first intermediate electrode piece 14a utilizing a mask, so as to cover a part of the source electrode 11 across the first organic semiconductor layer 13a.

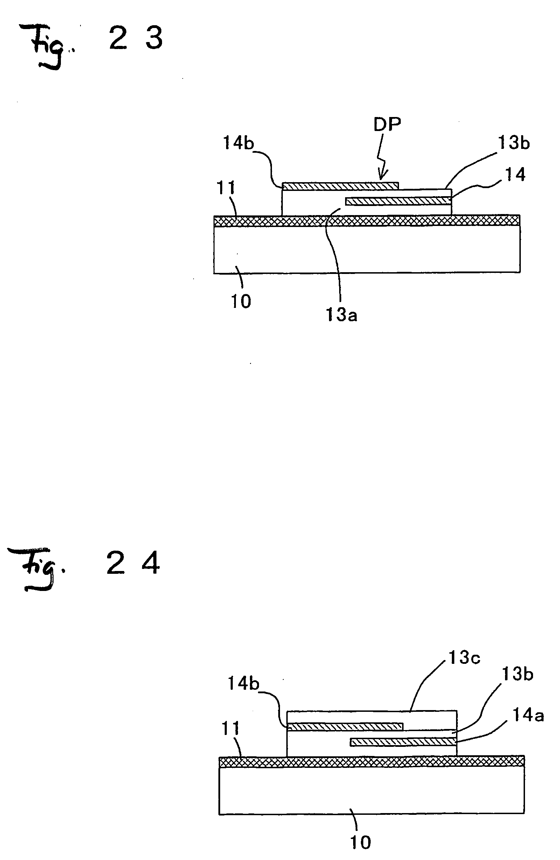

Then, as shown in Fig. 22, on the other part of the first organic semiconductor layer 13a and the first intermediate electrode piece 14a, a film of a-NPD same as in the first organic semiconductor layer is formed with a thickness of about 50 nm as the second organic semiconductor layer 13b. Then the entire substrate 10 is heated equal to or higher than a glass transition point of the organic semiconductor layer but equal to or less than the melting point thereof. More specifically, heating is executed at a temperature by 10 - 50° C than the glass transition temperature (96° C) of a-NPD, for example at 130° C for 10 minutes to embed the first intermediate electrode piece 14a in the second organic semiconductor layer 13b, thereby planarizing the surface thereof. The second organic semiconductor layer 13b is softened, and, by gravity and surface tension, fuses with the first organic semiconductor layer 13a. The heating process may be executed in the air, but, for the purpose of avoiding material deterioration or contamination, it is preferably executed in a vacuum chamber or in a nitrogen-replaced chamber. A softening temperature is about 150°C for an organic material with a glass transition temperature of 96°C, and a heating time required for softening is about 5 minutes. The entire substrate is heated by a heater in a reduced-pressure chamber or a vacuum chamber, and for example a halide lamp may be employed as heating means.

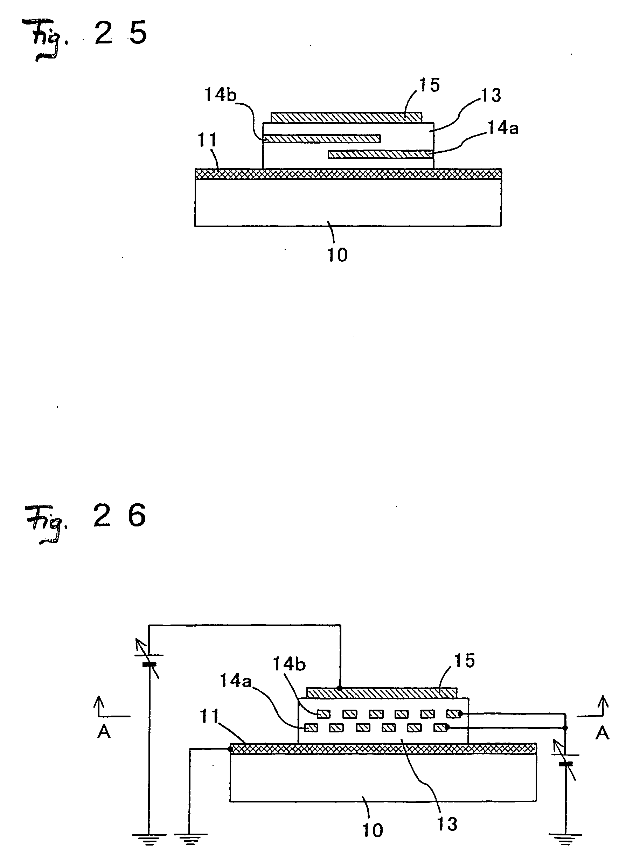

Then, as shown in Fig. 23, on a part of an upper surface of the second organic semiconductor layer 13b, Al is formed in a flat plate shape with a thickness of 50 nm by a resistance-heated evaporation as the second intermediate electrode piece 14b utilizing a mask, so as to cover another part of the source electrode 11 across the second organic semiconductor layer 13b. The second intermediate electrode piece 14b and the first intermediate electrode piece 14a are so formed as to cover the source electrode 11 in a mutually complementary form. The first intermediate electrode piece 14a and the second intermediate electrode piece 14b may be so formed, as shown in Fig. 24 as to have overlapping portions DP mutually separated across the second organic semiconductor layer 13b. The second intermediate electrode piece 14b is so formed as to be electrically connected with the first intermediate electrode piece 14a thereby realizing a same potential in the gate electrode 14. By such film formation of the second organic semiconductor layer 13b, the distance between the first intermediate electrode piece 14a and the second intermediate electrode piece 14b can be made smaller than the gap between the slat-shaped branches of a prior gate electrode formed utilizing a mask in a single plane, and such pieces can be formed in a close relationship separated by the thickness of a film, with a high precision in the distance of the electrode pieces.

Then, as shown in Fig. 24, on the other part of the second organic semiconductor layer 13b and the second intermediate electrode piece 14b, a film of a-NPD same as in the first organic semiconductor layer is formed with a thickness of about 50 nm as the third organic semiconductor layer 13c. Then the entire substrate 10 is heated equal to or higher than a glass transition point of the organic semiconductor layer but equal to or less than the melting point thereof in the same manner as explained before, thereby embedding the second intermediate electrode piece 14b in the third organic semiconductor layer 13c and planarizing the surface.

Finally, as shown in Fig. 25, on the third organic semiconductor layer 13c, a film of Al is formed with a thickness of 200 nm as the drain electrode 15 by a resistance-heated evaporation. The heat treatment after the formation of the organic semiconductor layer planarizes the organic semiconductor layer thereby providing an organic transistor having uniform organic semiconductor layers without surface irregularities.

In the foregoing embodiment, the first, second and third organic semiconductor layers 13a, 13b, 13c are formed by a-NPD which is a p-type material, but an n-type material may also be employed. The organic semiconductor layer may be formed by a material having at least either of the electron transporting property and the positive hole transporting property.

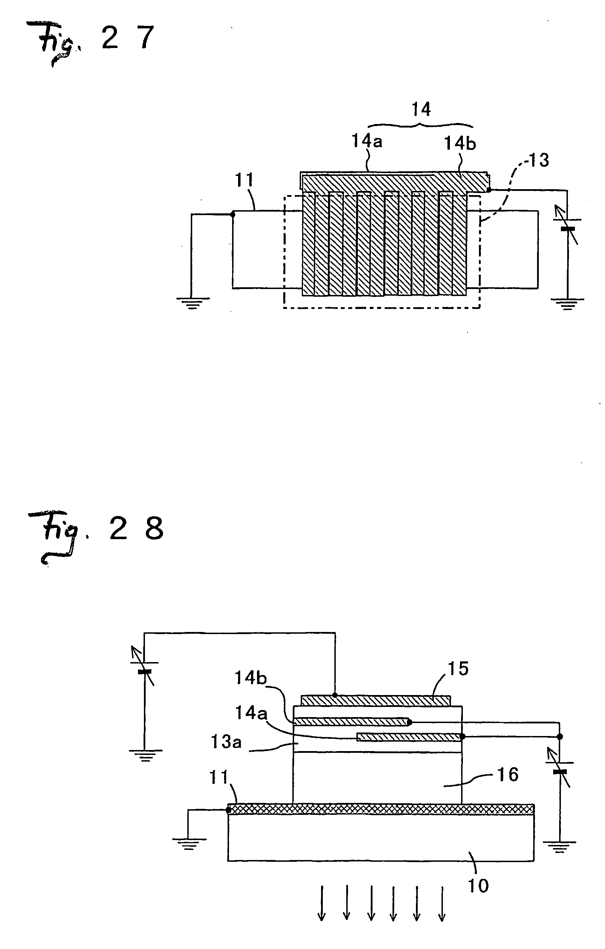

Also in the foregoing embodiment, the intermediate electrode pieces 14a, 14b are formed in a flat plate shape, but it is also possible to form the intermediate electrode pieces 14a, 14b of the gate electrode 14, positioned in two planes between the source electrode 11 and the drain electrode 15, as plural slat-shaped branches in a comb-like or screen-like pattern as shown in Fig. 26. Also in such case, the intermediate electrode pieces 14a, 14b, as shown in Fig. 27, are mutually connected electrically as the gate electrode 14 and are so formed, when observed from the side of the source electrode 11 or the drain electrode 15, as to cover these electrodes in a mutually complementary manner as shown in Fig. 27.

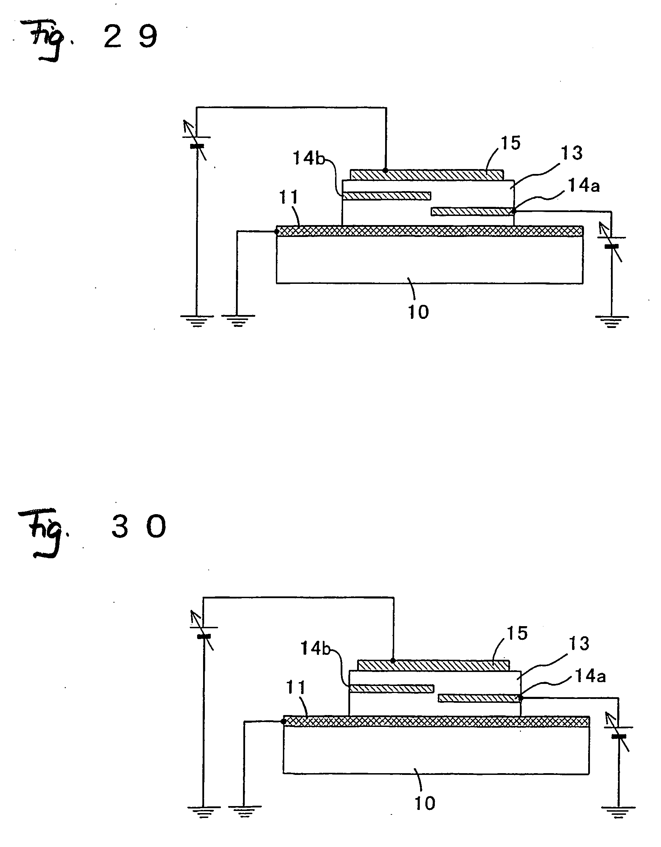

Furthermore, in the organic transistor of the aforementioned SIT structure, an electroluminescence device integral with an organic transistor can be constructed, as shown in Fig. 28, by forming the first, second and third organic semiconductor layers 13a, 13b, 13c as positive hole transport layers and providing an organic light-emitting layer 16 of an electron transporting property between the source electrode 11 and the first organic semiconductor layer 13a. It is thus rendered possible to form plural organic EL devices, each provided with an active device formed by organic material layers including an organic light-emitting layer constituted of at least a film of an organic compound showing an electroluminescence (EL) or a light emission by a current injection, in a predetermined pattern such as a matrix on a display panel substrate.

An organic EL device is formed by laminating organic material layers in succession between a pair of electrode layers which are provided on a substrate and one of which at a light emitting side is constituted of a transparent material. For example in a top-emission configuration, the organic light emission layer 16 may be provided between the drain electrode 15 and the third organic semiconductor layer 13c in a configuration opposite to that shown in Fig. 28.

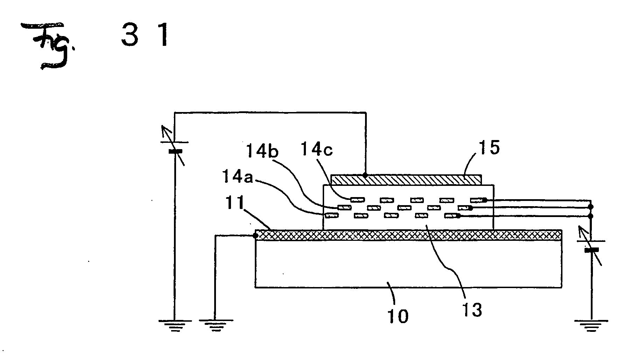

In another embodiment of the organic transistor of the invention, as shown in Figs. 29 and 30, the first intermediate electrode piece 14a and the second intermediate electrode piece 14b may be so formed as not to have portions that mutually overlap across the second organic semiconductor layer 13b.

Also in another embodiment of the organic transistor of the invention, as shown in Fig. 31, the intermediate electrode pieces 14a, 14b, 14c of the gate electrode, each formed as plural slat-shaped branches of a comb-shaped or screen-like pattern, are provided respectively in three planes between the source electrode 11 and the drain electrode 15.

## Claims

1. An organic semiconductor device comprising: a source electrode; a drain electrode; and a p-type organic semiconductor layer sandwiched between the source electrode and the drain electrode, **characterized by** further comprising an n-type organic semiconductor layer formed in an intermediate portion of the p-type organic semiconductor layer; and a gate electrode embedded in the n-type organic semiconductor layer.

2. An organic semiconductor device according to claim 1, **characterized in that** the gate electrode has a flat plate shape.

3. An organic semiconductor device according to claim 1, **characterized in that** the gate electrode is formed in a comb-like or screen-like pattern.

4. An organic semiconductor device comprising: a source electrode; a drain electrode; and a n-type organic semiconductor layer sandwiched between the source electrode and the drain electrode, **characterized by** further comprising a p-type organic semiconductor layer formed in an intermediate portion of said n-type organic semiconductor layer and a gate electrode embedded in said p-type organic semiconductor layer.

5. An organic semiconductor device according to claim 4, **characterized in that** the gate electrode has a flat plate shape.

6. An organic semiconductor device according to claim 4, **characterized in that** the gate electrode is formed in a comb-like or screen-like pattern.

7. An organic semiconductor device comprising: a source electrode; a drain electrode; and an organic semiconductor layer sandwiched between the source electrode and the drain electrode and having a carrier transporting property, **characterized by** further comprising a gate electrode constituted of at least two intermediate electrode pieces which are embedded in the organic semiconductor layer, wherein the intermediate electrode pieces are respectively provided in at least two planes separated from and parallel to the source electrode and the drain electrode, and are positioned in a direction across the layer thickness.

8. An organic semiconductor device according to claim 7, **characterized in that** the intermediate electrode piece has a flat plate shape.

9. An organic semiconductor device according to claim 7, **characterized in that** the intermediate electrode piece is formed in a comb-like or screen-like pattern.

10. An organic semiconductor device according to any of claims 7 to 9, **characterized in that** the organic semiconductor layer is constituted of a material having at least either of an electron transporting property and a positive hole transporting property.

11. An organic semiconductor device according to any of claims 7 to 9, **characterized in that** the two intermediate electrode pieces have overlapping portions which are mutually separated across a part of the organic semiconductor layer.

12. A method for producing an organic semiconductor device provided with an organic semiconductor layer formed between a source electrode and a drain electrode and embedding a gate electrode therein, the method being **characterized by** comprising:
a first organic semiconductor layer laminating step of forming a first organic semiconductor layer on either of a source electrode and a drain electrode;
a first intermediate electrode piece laminating step of forming a first intermediate electrode piece on a part of the first organic semiconductor layer;
a second organic semiconductor layer laminating step of forming a second organic semiconductor layer on the first organic semiconductor layer and the first intermediate electrode piece;
a second intermediate electrode piece laminating step of forming a second intermediate electrode piece on a part of the second organic semiconductor layer so as to cover the source electrode and the drain electrode in a complementary manner with the first intermediate electrode piece; and
a third organic semiconductor layer laminating step of forming a third organic semiconductor layer on the second organic semiconductor layer and the second intermediate electrode piece;
wherein each of the second and third organic semiconductor layer laminating step includes an embedding step of softening the formed organic semiconductor and embedding the intermediate electrode piece therein.

13. A method for producing an organic semiconductor device according to claim 12, **characterized in that** the embedding step heats the first organic semiconductor layer to a temperature equal to or higher than a glass transition temperature thereof but equal to or lower than a melting point thereof.

14. A method for producing an organic semiconductor device according to claim 12, **characterized in that** the organic semiconductor layer is formed by an evaporation method.
